# EUROPEAN PATENT APPLICATION

(11) **EP 4 738 328 A1**
(43) Date of publication of application: **06.05.2026**
(21) Application number: 25210812.1
(22) Date of filing: 23.10.2025
(51) Int. Cl.: G09G 3/32

(54) **GATE DRIVER AND ELECTRONIC DEVICE HAVING THE SAME**

(30) Priority: 30.10.2024 KR 20240150254
(71) Applicant: Samsung Display Co., Ltd., Yongin-si, Gyeonggi-do 17113 (KR)
(72) Inventor: Jeong, Junki, Yongin-si, Gyeonggi-do (KR); Seo, Youngwan, Yongin-si, Gyeonggi-do (KR); An, Jongyeop, Yongin-si, Gyeonggi-do (KR)
(74) Representative: Gulde & Partner

(57) **Abstract**

A gate driver includes an input circuit to transmit an input signal to a first control node responsive to a first clock signal; a pull-up circuit to pull up a gate output signal to a high voltage responsive to a signal of a second control node; a pull-down circuit to pull down the gate output signal to a first low voltage responsive to a signal of a third control node; a node separating circuit including a control electrode to receive the high voltage, a first electrode connected to the first control node and a second electrode connected to the second control node; a first control node control circuit to control a signal of the first control node responsive to the signal of the third control node; and a third control node control circuit to control the signal of the third control node responsive to the signal of the first control node.

## Description

### FIELD

Embodiments of the present inventive concept relate to a gate driver, a display apparatus including the gate driver and an electronic device including the gate driver. More particularly, embodiments of the present inventive concept relate to a gate driver with minimized power consumption, an electronic device including the gate driver, and a display apparatus including the gate driver or electronic device.

### INTRODUCTION

A display apparatus may include a display panel and a display panel driver. The display panel may include a plurality of gate lines, a plurality of data lines, a plurality of emission lines, and a plurality of pixels. The display panel driver may include a gate driver, a data driver, an emission driver and a driving controller. The gate driver outputs gate signals to the gate lines. The data driver outputs data voltages to the data lines. The emission driver outputs emission signals to the emission lines. The driving controller controls the gate driver, the data driver and the emission driver.

The display panel and the display panel driver may include P-type transistors and/or N-type transistors. To reduce or prevent a current leakage in the display panel, the display panel may include primarily N-type transistors. But even if the display panel includes exclusively N-type transistors while the gate driver of the display panel driver is integrated with the display panel and includes P-type transistors, a manufacturing process might be complex and/or current leakage might occur in the manufactured gate driver.

In addition, a flicker might occur on the display panel due to the current leakage and diminish display quality of the display panel.

When a clock signal is used as a gate output signal of the gate driver, power consumption might be high due to capacitance of a buffer transistor receiving the clock signal.

In addition, when the gate driver is driven by a clock signal used as the gate output signal and a carry clock signal used as a carry signal of the gate driver, a size of the buffer transistor might be insufficient due to spatial limitations or the like so that a falling time of the gate output signal might be slow.

When the falling time of the gate output signal is slow, a data voltage of another pixel might be incorrectly applied to a current pixel and diminish display quality of the display panel.

### SUMMARY

Embodiments of the present inventive concept may provide a gate driver to maximize display quality and minimize power consumption.

Embodiments of the present inventive concept may provide a display apparatus including the gate driver.

Embodiments of the present inventive concept may provide an electronic device including the gate driver.

In a gate driver according to an embodiment of the present inventive concept, the gate driver includes stages. A stage includes a first transistor having a 1-1 sub-transistor including a control electrode connected to a first clock signal line, a first electrode connected to an input signal line and a second electrode connected to a first intermediate node, and a 1-2 sub-transistor including a control electrode connected to the first clock signal line, a first electrode connected to the first intermediate node and a second electrode connected to a first control node, a second transistor having a 2-1 sub-transistor including a control electrode connected to a third control node, a first electrode connected to the first intermediate node and a second electrode connected to the first control node, and a 2-2 sub-transistor including a control electrode connected to the third control node, a first electrode connected to a second low voltage line and a second electrode connected to the first intermediate node, a third transistor including a control electrode connected to a high voltage line, a first electrode connected to the first control node and a second electrode connected to a second control node, a fifth transistor including a control electrode connected to the second control node, a first electrode connected to the high voltage line and a second electrode connected to a carry output terminal, a sixth transistor including a control electrode connected to the third control node, a first electrode connected to the second low voltage line and a second electrode connected to the carry output terminal, a seventh transistor including a control electrode connected to the second control node, a first electrode connected to the high voltage line and a second electrode connected to a gate output terminal and an eighth transistor including a control electrode connected to the third control node, a first electrode connected to a first low voltage line and a second electrode connected to the gate output terminal.

In an embodiment, the stage may further include a fourth transistor including a control electrode connected to the second control node, a first electrode connected to a second clock signal line and a second electrode connected to a second electrode of a first capacitor, the first capacitor including a first electrode connected to the second control node.

In an embodiment, the stage may further include a second capacitor including a first electrode connected to the second control node and a second electrode connected to the gate output terminal.

In an embodiment, the stage may further include a ninth transistor having a 9-1 sub-transistor including a control electrode connected to the high voltage line, a first electrode connected to a first node and a second electrode connected to a ninth intermediate node, and a 9-2 sub-transistor including a control electrode connected to the high voltage line, a first electrode connected to the ninth intermediate node and a second electrode connected to the high voltage line and a tenth transistor including a control electrode connected to the first node, a first electrode connected to the high voltage line and a second electrode connected to the third control node.

In an embodiment, the stage may further include a third capacitor including a first electrode connected to the first node and a second electrode connected to the third control node.

In an embodiment, the stage may further include an eleventh transistor including a control electrode connected to the first control node, a first electrode connected to the first low voltage line and a second electrode connected to the first node and a twelfth transistor including a control electrode connected to the first control node, a first electrode connected to the second low voltage line and a second electrode connected to the third control node.

In an embodiment, the stage may further include a thirteenth transistor having a 13-1 sub-transistor including a control electrode connected to the first control node, a first electrode connected to the high voltage line and a second electrode connected to a thirteenth intermediate node and a 13-2 sub-transistor including a control electrode connected to the first control node, a first electrode connected to the thirteenth intermediate node and a second electrode connected to the first intermediate node.

In an embodiment, the stage may further include a fourteenth transistor having a 14-1 sub-transistor including a control electrode connected to a reset signal line, a first electrode connected to the first intermediate node and a second electrode connected to the first control node and a 14-2 sub-transistor including a control electrode connected to the reset signal line, a first electrode connected to the first low voltage line and a second electrode connected to the first intermediate node.

In an embodiment, the stages may include a first stage, a second stage, a third stage and a fourth stage which are sequentially disposed. A carry signal of the first stage is connected to the second stage. A carry signal of the second stage is connected to the third stage. A carry signal of the third stage is connected to the fourth stage. The first clock signal line may be connected to a first clock terminal of the first stage and a second clock signal line may be connected to a second clock terminal of the first stage. The second clock signal line may be connected to a first clock terminal of the second stage and the first clock signal line may be connected to a second clock terminal of the second stage. The first clock signal line may be connected to a first clock terminal of the third stage and the second clock signal line may be connected to a second clock terminal of the third stage. The second clock signal line may be connected to a first clock terminal of the fourth stage and the first clock signal line may be connected to a second clock terminal of the fourth stage.

In an embodiment, a cycle of a first clock signal of the first clock signal line may be two horizontal periods. A cycle of a second clock signal of the second clock signal line may be two horizontal periods. A high period of a pulse of a gate output signal may be two horizontal periods.

In an embodiment, a high period of the first clock signal need not overlap a high period of the second clock signal.

In an embodiment, the stages may include a first stage, a second stage, a third stage and a fourth stage which are sequentially disposed. A carry signal of the first stage may be connected to the third stage. A carry signal of the second stage may be connected to the fourth stage. The first clock signal may be applied to a first clock terminal of the first stage and a second clock signal is applied to a second clock terminal of the first stage. A third clock signal may be applied to a first clock terminal of the second stage and a fourth clock signal may be applied to a second clock terminal of the second stage. The second clock signal may be applied to a first clock terminal of the third stage and the first clock signal may be applied to a second clock terminal of the third stage. The fourth clock signal may be applied to a first clock terminal of the fourth stage and the third clock signal is applied to a second clock terminal of the fourth stage.

In an embodiment, a cycle of the first clock signal may be four horizontal periods. A cycle of the second clock signal may be four horizontal periods. A cycle of the third clock signal may be four horizontal periods. A cycle of the fourth clock signal may be four horizontal periods. A high period of a pulse of a gate output signal may be four horizontal periods.

In an embodiment, a high period of the first clock signal need not overlap a high period of the second clock signal. A high period of the third clock signal may overlap the high period of the first clock signal. The high period of the third clock signal may overlap the high period of the second clock signal.

In a gate driver according to an embodiment of the present inventive concept, the gate driver includes an input circuit, a pull-up circuit, a pull-down circuit, a node separating circuit, a first control node control circuit and a third control node control circuit. The input circuit is configured to transmit an input signal to a first control node in response to a first clock signal. The pull-up circuit is configured to pull up a gate output signal to a high voltage in response to a signal of a second control node. The pull-down circuit is configured to pull down the gate output signal to a first low voltage in response to a signal of a third control node. The node separating circuit may include a control electrode configured to receive the high voltage, a first electrode connected to the first control node and a second electrode connected to the second control node. The first control node control circuit is configured to control a signal of the first control node in response to the signal of the third control node. The third control node control circuit is configured to control the signal of the third control node in response to the signal of the first control node.

In an electronic device according to an embodiment of the present inventive concept, the electronic device includes a display panel, a gate driver and a data driver. The display panel includes a pixel. The gate driver is configured to output a gate signal to the pixel. The data driver is configured to output a data voltage to the pixel. The gate driver may include a first transistor having a 1-1 sub-transistor including a control electrode configured to receive a first clock signal, a first electrode configured to receive an input signal and a second electrode connected to a first intermediate node, and a 1-2 sub-transistor including a control electrode configured to receive the first clock signal, a first electrode connected to the first intermediate node and a second electrode connected to a first control node, a second transistor having a 2-1 sub-transistor including a control electrode connected to a third control node, a first electrode connected to the first intermediate node and a second electrode connected to the first control node, and a 2-2 sub-transistor including a control electrode connected to the third control node, a first electrode configured to receive a second low voltage and a second electrode connected to the first intermediate node, a third transistor including a control electrode configured to receive a high voltage, a first electrode connected to the first control node and a second electrode connected to a second control node, a fifth transistor including a control electrode connected to the second control node, a first electrode configured to receive the high voltage and a second electrode connected to a carry output terminal, a sixth transistor including a control electrode connected to the third control node, a first electrode configured to receive the second low voltage and a second electrode connected to the carry output terminal, a seventh transistor including a control electrode connected to the second control node, a first electrode configured to receive the high voltage and a second electrode connected to a gate output terminal and an eighth transistor including a control electrode connected to the third control node, a first electrode configured to receive a first low voltage and a second electrode connected to the gate output terminal.

In an embodiment, the gate driver may further include a fourth transistor including a control electrode connected to the second control node, a first electrode configured to receive a second clock signal and a second electrode connected to a second electrode of a first capacitor, the first capacitor including a first electrode connected to the second control node and the second electrode.

In an embodiment, the gate driver may further include a second capacitor including a first electrode connected to the second control node and a second electrode connected to the gate output terminal.

In an embodiment, the gate driver may further include a ninth transistor having a 9-1 sub-transistor including a control electrode configured to receive the high voltage, a first electrode connected to a first node and a second electrode connected to a ninth intermediate node, and a 9-2 sub-transistor including a control electrode configured to receive the high voltage, a first electrode connected to the ninth intermediate node and a second electrode configured to receive the high voltage and a tenth transistor including a control electrode connected to the first node, a first electrode configured to receive the high voltage and a second electrode connected to the third control node.

In an embodiment, the electronic device further includes a driving controller and a processor. The driving controller is configured to control the gate driver and the data driver. The processor is configured to output input image data to the driving controller.

According to an embodiment of the gate driver, the display apparatus including the gate driver and the electronic device including the gate driver, all transistors in the gate driver may be configured as N-type transistors. The gate driver need not include any P-type transistors but may include exclusively, N-type transistors. For example, all transistors in the gate driver may be configured as oxide semiconductor thin film transistors.

To substantially prevent current leakage, the display panel includes exclusively, N-type transistors and the gate driver integrated with the display panel also includes exclusively, N-type transistors so that the manufacturing process may be simplified and current leakage may be substantially prevented in the display panel and in the gate driver. Moreover, flicker due to such current leakage may be substantially prevented so that the display quality of the display panel may be maximized. The term substantially means in this context that the flicker is not recognizable by the observer anymore, particularly above 300 fps.

In addition, the reliability and the stability of the gate output signal may be maximized and the power consumption may be minimized.

In addition, the gate driver need not use the clock signal as the gate output signal but may generate the gate output signal based on a power voltage so that the power consumption increase due to a capacitance of a buffer transistor receiving the clock signal may be substantially prevented.

In addition, the gate driver need not receive additional carry clock signals so that a size of the buffer transistor may be sufficiently large and a falling time of the gate output signal may be decreased.

When the falling time of the gate output signal is decreased, a data voltage of another pixel need not be incorrectly applied to a pixel so that a display quality of the display panel may be maximized.

### BRIEF DESCRIPTION OF THE DRAWINGS

The above and other embodiments of the present inventive concept will become more apparent by describing in detail illustrative examples thereof with reference to the accompanying drawings, in which:
FIG. 1 is a block diagram illustrating a display apparatus according to an embodiment of the present inventive concept;
FIG. 2 is a block diagram illustrating a gate driver of FIG. 1;
FIG. 3 is a circuit diagram illustrating a stage of the gate driver of FIG. 2;
FIG. 4 is a timing diagram illustrating input signals, node signals and output signals of the gate driver of FIG. 2;
FIG. 5 is a block diagram illustrating a gate driver of a display apparatus according to an embodiment of the present inventive concept;
FIG. 6 is a timing diagram illustrating input signals, node signals and output signals of the gate driver of FIG. 5;
FIG. 7 is a circuit diagram illustrating a stage of a gate driver of a display apparatus according to an embodiment of the present inventive concept;
FIG. 8 is a timing diagram illustrating input signals, node signals and output signals of the gate driver of FIG. 7;
FIG. 9 is a block diagram illustrating an electronic device according to an embodiment of the present inventive concept;
FIG. 10 is an isometric diagram illustrating an example in which the electronic device of FIG. 9 is implemented as a smart phone;
FIG. 11 is an isometric diagram illustrating an example in which the electronic device of FIG. 9 is implemented as a monitor; and
FIG. 12 is a block diagram illustrating an electronic device according to an embodiment of the present inventive concept.

### DETAILED DESCRIPTION

Hereinafter, embodiments of the present inventive concept may be explained in detail with reference to the accompanying drawings.

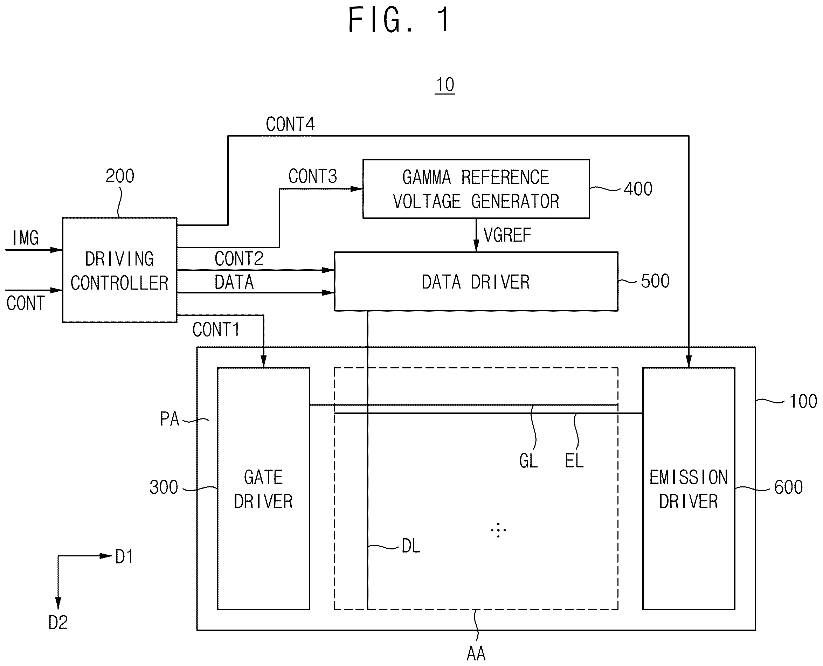

FIG. 1 illustrates a display apparatus 10 according to an embodiment of the present inventive concept.

Referring to FIG. 1, the display apparatus 10 includes a display panel 100 and a display panel driver. The display panel driver includes a driving controller 200, a gate driving circuit or gate driver 300, a gamma reference voltage generator 400, a data driver 500 and an emission driver 600.

The display panel 100 has a display region AA on which an image is displayed and a peripheral region PA adjacent to the display region AA on which the image is not displayed.

The display panel 100 may include a plurality of gate lines GL, a plurality of data lines DL, a plurality of emission lines EL and a plurality of pixels electrically connected to the gate lines GL, the data lines DL and the emission lines EL. The gate lines GL may extend in a first direction D1, the data lines DL may extend in a second direction D2 crossing the first direction D1 and the emission lines EL may extend in the first direction D1, without limitation thereto.

The driving controller 200 may receive input image data IMG and an input control signal CONT from an external apparatus. For example, the input image data IMG may include red image data, green image data and blue image data. The input image data IMG may include white image data. The input image data IMG may include magenta image data, cyan image data and yellow image data. The input control signal CONT may include a master clock signal and a data enable signal. The input control signal CONT may further include a vertical synchronizing signal and a horizontal synchronizing signal.

The driving controller 200 generates a first control signal CONT1, a second control signal CONT2, a third control signal CONT3, a fourth control signal CONT4 and a data signal DATA based on the input image data IMG and the input control signal CONT.

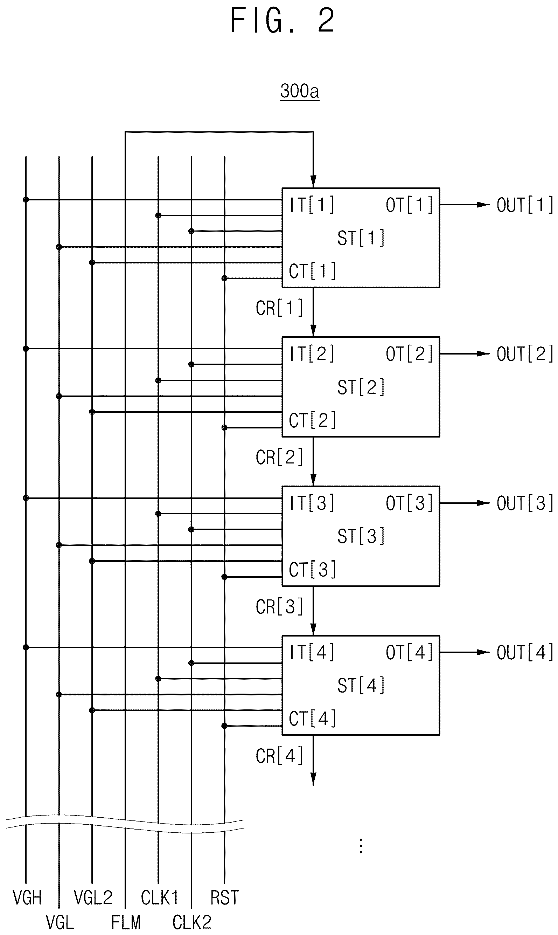

The driving controller 200 generates the first control signal CONT1 for controlling an operation of the gate driver 300 based on the input control signal CONT, and outputs the first control signal CONT1 to the gate driver 300. The first control signal CONT1 may include a vertical start signal such as in the signals FLM or IN[1] of FIGS. 2, 3 and 4, and a gate clock signal such as in the signals CLK1 or CLK2 of FIGS. 2, 3 and 4, without limitation thereto.

The driving controller 200 generates the second control signal CONT2 for controlling an operation of the data driver 500 based on the input control signal CONT, and outputs the second control signal CONT2 to the data driver 500. The second control signal CONT2 may include a horizontal start signal and a load signal.

The driving controller 200 generates the data signal DATA based on the input image data IMG. The driving controller 200 outputs the data signal DATA to the data driver 500.

The driving controller 200 generates the third control signal CONT3 for controlling an operation of the gamma reference voltage generator 400 based on the input control signal CONT, and outputs the third control signal CONT3 to the gamma reference voltage generator 400.

The driving controller 200 generates the fourth control signal CONT4 for controlling an operation of the emission driver 600 based on the input control signal CONT, and outputs the fourth control signal CONT4 to the emission driver 600.

The gate driver 300 generates gate signals driving the gate lines GL in response to the first control signal CONT1 received from the driving controller 200. The gate driver 300 may output the gate signals to the gate lines GL. For example, the gate driver 300 may be integrated with the peripheral region PA of the display panel 100. For example, the gate driver 300 may be mounted on the peripheral region PA of the display panel 100.

The gamma reference voltage generator 400 generates a gamma reference voltage VGREF in response to the third control signal CONT3 received from the driving controller 200. The gamma reference voltage generator 400 provides the gamma reference voltage VGREF to the data driver 500. The gamma reference voltage VGREF is used for converting the data signal DATA into the data voltage having an analog type.

In an embodiment, the gamma reference voltage generator 400 may be disposed in the driving controller 200, or in the data driver 500.

The data driver 500 receives the second control signal CONT2 and the data signal DATA from the driving controller 200, and receives the gamma reference voltages VGREF from the gamma reference voltage generator 400. The data driver 500 converts the data signals DATA into the data voltages having an analog type using the gamma reference voltages VGREF. The data driver 500 outputs the data voltages to the data lines DL.

The emission driver 600 generates emission signals to drive the emission lines EL in response to the fourth control signal CONT4 received from the driving controller 200. The emission driver 600 may output the emission signals to the emission lines EL. For example, the emission driver 600 may be integrated with the peripheral region PA of the display panel 100. For example, the emission driver 600 may be mounted on the peripheral region PA of the display panel 100.

Although the gate driver 300 is disposed at a first side of the display panel 100 and the emission driver 600 is disposed at a second side of the display panel 100 opposite to the first side in FIG. 1 for convenience of explanation, the present inventive concept is not limited thereto. For example, both of the gate driver 300 and the emission driver 600 may be disposed at the first side of the display panel 100. For example, both of the gate drivers 300 and the emission drivers 600 may be disposed at both sides of the display panel 100. For example, the gate driver 300 and the emission driver 600 may be integrally formed, in particular on an integrated circuit board to reduce size.

In an embodiment, the display panel 100 exclusively uses N-type transistors, and the gate driver 300 integrated with the display panel exclusively uses N-type transistors. Thus, a manufacturing process may be simplified and current leakage may be minimized or substantially prevented in each of the display panel 100 and the gate driver 300. Flicker due to such current leakage may similarly be minimized or substantially prevented, and the display quality of the display panel 100 may be maximized. In addition, the reliability and the stability of the gate output signal OUT[n] may be maximized and the power consumption may be minimized. The gate driver 300 need not use the clock signals CLK1 and CLK2 as the gate output signal OUT[n] since the gate output signal OUT[n] is generated based on power voltages VGH and VGL, and a power consumption increase due to a capacitance of a gate driver output buffer transistor receiving the clock signals may be avoided. Moreover, the gate driver 300 need not receive additional carry clock signals, so a size of the seventh transistor T7 is large enough that a falling time of the gate output signal OUT[n] may be minimized. When the falling time of the gate output signal OUT[n] is minimized, a data voltage of another pixel is not likely to be incorrectly applied to a current pixel, so display quality of the display panel 100 may be maximized.

FIG. 2 illustrates a gate driver 300a as a non-limiting example of the gate driver 300 of FIG. 1.

Referring to FIGS. 1 and 2, in the present embodiment, the gate driver 300a may include stages ST[1], ST[2], ST[3] and ST[4]. For example, the stages may include a first stage ST[1], a second stage ST[2], a third stage ST[3] and a fourth stage ST[4] which are sequentially disposed.

A high voltage VGH, a first low voltage VGL, a second low voltage VGL2, a first clock signal CLK1 and a second clock signal CLK2 may be applied to the stages ST[1], ST[2], ST[3] and ST[4]. In addition, a reset signal RST may be applied to the stages ST[1], ST[2], ST[3] and ST[4]. The first clock signal CLK1 and the second clock signal CLK2 may be applied to the stages ST[1], ST[2], ST[3] and ST[4], but any additional carry clock signals for generating a carry signal need not be applied to the stages ST[1], ST[2], ST[3] and ST[4].

For example, the second low voltage VGL2 may have a level lower than a level of the first low voltage VGL.

The first clock signal CLK1 and the second clock signal CLK2 may be alternately applied to the stages ST[1], ST[2], ST[3] and ST[4]. For example, the first clock signal CLK1 may be applied to a first clock terminal of the first stage ST[1] and the second clock signal CLK2 may be applied to a second clock terminal of the first stage ST[1]. In contrast, the second clock signal CLK2 may be applied to a first clock terminal of the second stage ST[2] and the first clock signal CLK1 may be applied to a second clock terminal of the second stage ST[2].

Like the first stage ST[1], the first clock signal CLK1 may be applied to a first clock terminal of the third stage ST[3] and the second clock signal CLK2 may be applied to a second clock terminal of the third stage ST[3]. Like the second stage ST[2], the second clock signal CLK2 may be applied to a first clock terminal of the fourth stage ST[4] and the first clock signal CLK1 may be applied to a second clock terminal of the fourth stage ST[4].

The vertical start signal FLM may be applied to an input terminal IT[1] of the first stage ST[1]. A first carry signal CR[1] of the first stage ST[1] may be applied to an input terminal IT[2] of the second stage ST[2]. A second carry signal CR[2] of the second stage ST[2] may be applied to an input terminal IT[3] of the third stage ST[3]. A third carry signal CR[3] of the third stage ST[3] may be applied to an input terminal IT[4] of the fourth stage ST[4].

Carry terminals CT[1] to CT[4] of the first to fourth stages ST[1] to ST[4] may output first to fourth carry signals CR[1] to CR[4].

Gate output terminals OT[1] to OT[4] of the first to fourth stages ST[1] to ST[4] may output first to fourth gate output signals OUT[1] to OUT[4].

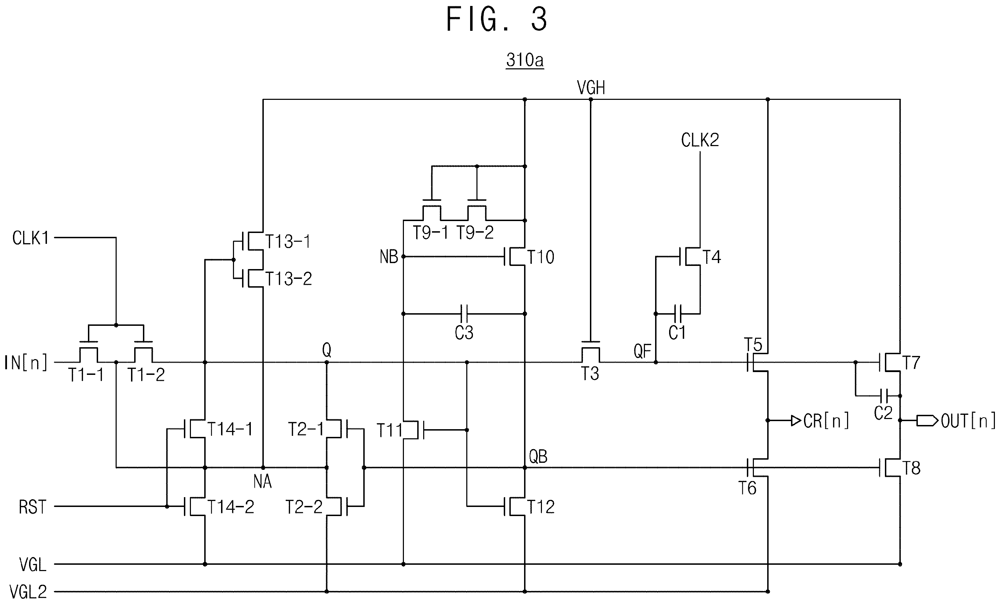

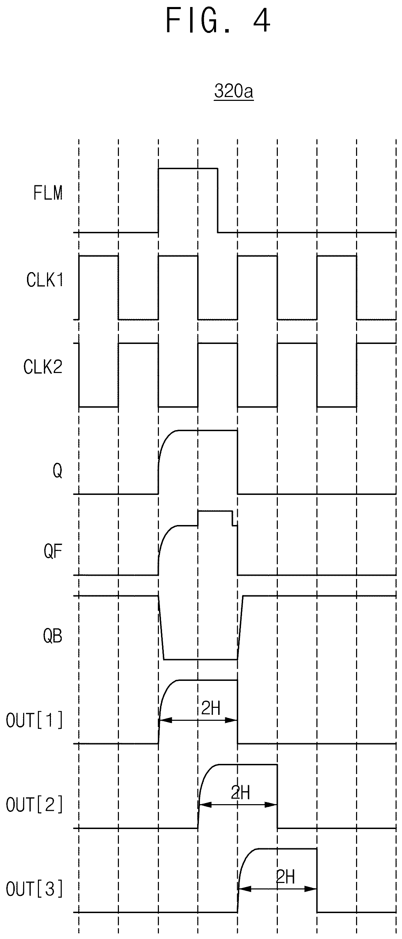

FIG. 3 illustrates a stage 310a of the gate driver 300a of FIG. 2. FIG. 4 illustrates signals 320a, including input signals, node signals and output signals of the gate driver 300a of FIG. 2.

Referring to FIGS. 1 to 4, the stage 310a of the gate driver 300a includes a pull-up circuit pulling up the gate output signal OUT[n] to the high voltage VGH in response to a signal of a second control node QF, a pull-down circuit pulling down the gate output signal OUT[n] to the first low voltage VGL in response to a signal of a third control node QB, a first control node control circuit controlling a signal of the first control node Q in response to the signal of the third control node QB and a third control node control circuit controlling the signal of the third control node QB in response to the signal of the first control node Q.

For example, the pull-up circuit may include a seventh transistor T7 including a control electrode connected to the second control node QF, a first electrode receiving the high voltage VGH and a second electrode connected to a gate output terminal and a second capacitor C2 connected to the control electrode (the second control node QF) of the seventh transistor T7 and the second electrode (the gate output terminal) of the seventh transistor T7. The second capacitor C2 may be a boosting capacitor boosting the pull-up of the gate output signal OUT[n].

For example, the pull-down circuit may include an eighth transistor T8. The eighth transistor T8 may include a control electrode connected to the third control node QB, a first electrode receiving the first low voltage VGL and a second electrode connected to the gate output terminal.

The third control node control circuit may include a 9-1 sub-transistor T9-1 including a control electrode receiving the high voltage VGH, a first electrode connected to a control electrode (a first node NB) of a tenth transistor T10 and a second electrode connected to a ninth intermediate node, a 9-2 sub-transistor T9-2 including a control electrode receiving the high voltage VGH, a first electrode connected to the ninth intermediate node and a second electrode receiving the high voltage VGH, the tenth transistor T10 including a control electrode connected to the first electrode (the first node NB) of the 9-1 sub-transistor T9-1, a first electrode receiving the high voltage VGH and a second electrode connected to the third control node QB.

The third control node control circuit may further include a third capacitor C3 including a first electrode connected to the control electrode (the first node NB) of the tenth transistor T10 and a second electrode connected to the third control node QB.

The third capacitor C3 may accelerate the turn-on and the turn-off of the tenth transistor T10 so that the display apparatus may operate quickly.

The third control node control circuit may further include an eleventh transistor T11 applying the first low voltage VGL to the control electrode (the first node NB) of the tenth transistor T10 in response to the signal of the first control node Q.

The third control node control circuit may further include a twelfth transistor T12 including a control electrode connected to the first control node Q, a first electrode receiving the second low voltage VGL2 and a second electrode connected to the third control node QB.

When the signal of the first control node Q has a high level, the eleventh transistor T11 may be turned on, the first low voltage VGL may be applied to the control electrode of the tenth transistor T10 by the eleventh transistor T11. The 9-1 sub-transistor T9-1 and the 9-2 sub-transistor T9-2 are turned on in response to the high voltage VGH so that the 9-1 sub-transistor T9-1, the 9-2 sub-transistor T9-2 and the eleventh transistor T11 are turned on in a time period when the signal of the first control node Q has a high level. When the 9-1 sub-transistor T9-1, the 9-2 sub-transistor T9-2 and the eleventh transistor T11 are turned on, a voltage drop may occur due to resistance components of the 9-1 sub-transistor T9-1 and the 9-2 sub-transistor T9-2 so that the signal of the control electrode of the tenth transistor T10 may maintain a level of the first low voltage VGL. Thus, even though all of the 9-1 sub-transistor T9-1, the 9-2 sub-transistor T9-2 and the eleventh transistor T11 are turned on, the tenth transistor may maintain a turned-off state well.

When the signal of the first control node Q has a high level, the tenth transistor T10 is turned off and the twelfth transistor T12 is turned on so that the signal of the third control node QB has a low level (e.g., VGL2).

In contrast, when the signal of the first control node Q has a low level, the 9-1 sub-transistor T9-1, the 9-2 sub-transistor T9-2 and the tenth transistor T10 are turned on but the eleventh transistor T11 and the twelfth transistor T12 are turned off so that the signal of the third control node QB has a high level (e.g., VGH).

The stage 310a of the gate driver 300a may further include a carry pull-up circuit pulling-up the carry signal CR[n] to the high voltage VGH in response to the signal of the second control node QF and a carry pull-down circuit pulling down the carry signal CR[n] to the second low voltage VGL2 in response to the signal of the third control node QB.

The carry pull-up circuit may include a fifth transistor T5 including a control electrode connected to the second control node QF, a first electrode receiving the high voltage VGH and a second electrode connected to a carry output terminal.

The carry pull-down circuit may include a sixth transistor T6 including a control electrode connected to the third control node QB, a first electrode receiving the second low voltage VGL2 and a second electrode connected to the carry output terminal.

In the present embodiment, the stage 310a of the gate driver 300a may further include a boosting circuit boosting the second control node QF using the second clock signal CLK2 in response to the signal of the second control node QF.

The boosting circuit may include a fourth transistor T4 including a control electrode connected to the second control node QF, a first electrode receiving the second clock signal CLK2 and a second electrode connected to a second electrode of a first capacitor C1, the first capacitor C1 including a first electrode connected to the second control node QF and the second electrode.

The stage 310a of the gate driver 300a may further include an input circuit transmitting an input signal IN[n] to the first control node Q in response to the first clock signal CLK1. The input signal IN[n] may be received through an input terminal IT[n] of the gate driver 300a, where the input signal IN[n] may correspond to the vertical start signal FLM where the stage is a first stage (e.g., n=1), the first carry signal CR[1] where the stage is a second stage (e.g., n=2), the second carry signal CR[2] where the stage is a third stage (e.g., n=3), the third carry signal CR[3] where the stage is a fourth stage (e.g., n=4), or the (n-1)^{th} carry signal CR[n-1] where the stage is an n^{th} stage.

The input circuit may include a 1-1 sub-transistor T1-1 including a control electrode receiving the first clock signal CLK1, a first electrode receiving the input signal IN[n] and a second electrode connected to a first intermediate node NA and a 1-2 sub-transistor T1-2 including a control electrode receiving the first clock signal CLK1, a first electrode connected to the first intermediate node NA and a second electrode connected to the first control node Q.

The stage 310a of the gate driver 300a may further include a third transistor T3 including a control electrode receiving the high voltage VGH, a first electrode connected to the first control node Q and a second electrode connected to the second control node QF. The third transistor T3 may be a node separating circuit separating the first control node Q and the second control node QF. Advantageously, the third transistor may prevent the bootstrap voltage of the second control node QF from leaking to the first control node Q. As shown in FIG. 4, when the signal of the second control node QF is bootstrapped, the signal of the first control node Q need not be bootstrapped. The bootstrap voltage of the second control node QF need not leak to the first control node Q so that the pull-up circuit may stably output the gate output signal.

The stage 310a of the gate driver 300a may further include a first control node control circuit applying the second low voltage VGL2 to the first control node Q in response to the signal of the third control node QB.

The first control node control circuit may include a 2-1 sub-transistor T2-1 including a control electrode connected to the third control node QB, a first electrode connected to the first intermediate node NA and a second electrode connected to the first control node Q, and a 2-2 sub-transistor T2-2 including a control electrode connected to the third control node QB, a first electrode receiving the second low voltage VGL2 and a second electrode connected to the first intermediate node NA.

The stage 310a of the gate driver 300a may further include a reset circuit applying the first low voltage VGL to the first control node Q in response to the reset signal RST.

**The** reset circuit may include a 14-1 sub-transistor T14-1 including a control electrode receiving the reset signal RST, a first electrode connected to the first intermediate node NA and a second electrode connected to the first control node Q and a 14-2 sub-transistor T14-2 including a control electrode receiving the reset signal RST, a first electrode receiving the first low voltage VGL and a second electrode connected to the first intermediate node NA.

The reset signal RST may have an active level in an initial turning-on period of the display apparatus. An unintentional light emission may be prevented in the initial turning-on period of the display apparatus by the reset signal RST.

The stage 310a of the gate driver 300a may further include a stabilizing circuit applying the high voltage VGH to the first intermediate node NA and the second intermediate node NA in response to the signal of the Q node. The stabilizing circuit may also apply the high voltage VGH to the fifteenth intermediate node NA.

The stabilizing circuit may include a 13-1 sub-transistor T13-1 including a control electrode connected to the first control node Q, a first electrode receiving the high voltage VGH and a second electrode connected to a thirteenth intermediate node and a 13-2 sub-transistor T13-2 including a control electrode connected to first control node Q, a first electrode connected to the thirteenth intermediate node and a second electrode connected to the first intermediate node NA.

FIG. 4 illustrates the vertical start signal FLM, the first clock signal CLK1, the second clock signal CLK2, the signal of the first control node Q, the signal of the second control node QF, the signal of the third control node QB, the gate output signals OUT[1], OUT[2] and OUT[3] in a first frame. The waveforms of the above signals of the first frame may be repeated in a second frame.

In the present embodiment, a cycle of the first clock signal CLK1 may be two horizontal periods 2H, a cycle of the second clock signal CLK2 may be two horizontal periods 2H and a high period of a pulse of the gate output signal may be two horizontal periods 2H.

In the present embodiment, a high period of the first clock signal CLK1 need not overlap a high period of the second clock signal CLK2.

According to the present embodiment, all transistors in the gate driver 300a may be configured as the N-type transistors. The gate driver 300a need not include any P-type transistors but may include exclusively N-type transistors. For example, all transistors in the gate driver 300a may be configured to as oxide semiconductor thin film transistors.

To substantially prevent the current leakage, the display panel 100 includes exclusively N-type transistors and the gate driver 300a integrated with the display panel 100 also includes exclusively N-type transistors so that the manufacturing process may become simplified and the current leakage may be substantially prevented in the gate driver 300a. The flicker due to the current leakage may be substantially prevented so that the display quality of the display panel 100 may be maximized.

In addition, advantageously the reliability and the stability of the gate output signal OUT[n] may be maximized and the power consumption may be minimized.

In addition, the gate driver 300a need not use the clock signals CLK1 and CLK2 as the gate output signal OUT[n] but may instead generate the gate output signal OUT[n] based on power voltages VGH and VGL to substantially prevent a power consumption increase due to a capacitance of an alternate buffer transistor (e.g., compared with the seventh transistor T7) alternately configured for receiving the clock signals CLK1 and CLK2.

In addition, the gate driver 300a need not receive additional carry clock signals so a size of the buffer transistor (e.g., the seventh transistor T7) may be sufficiently large that a falling time of the gate output signal OUT[n] may be fast.

When the falling time of the gate output signal OUT[n] is fast, a data voltage of another pixel is unlikely to be incorrectly applied to a current pixel, so that a display quality of the display panel 100 may be maximized.

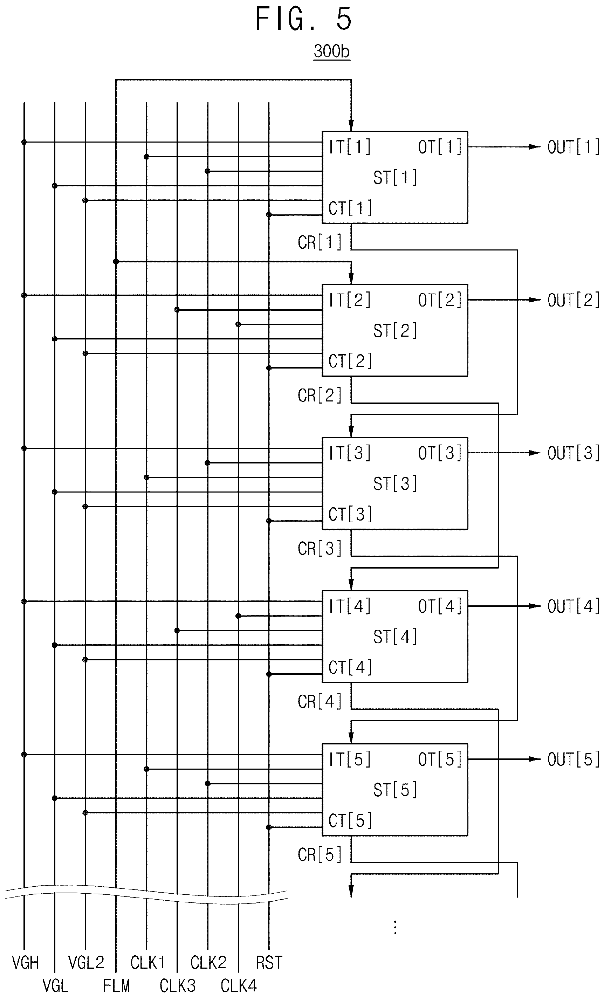

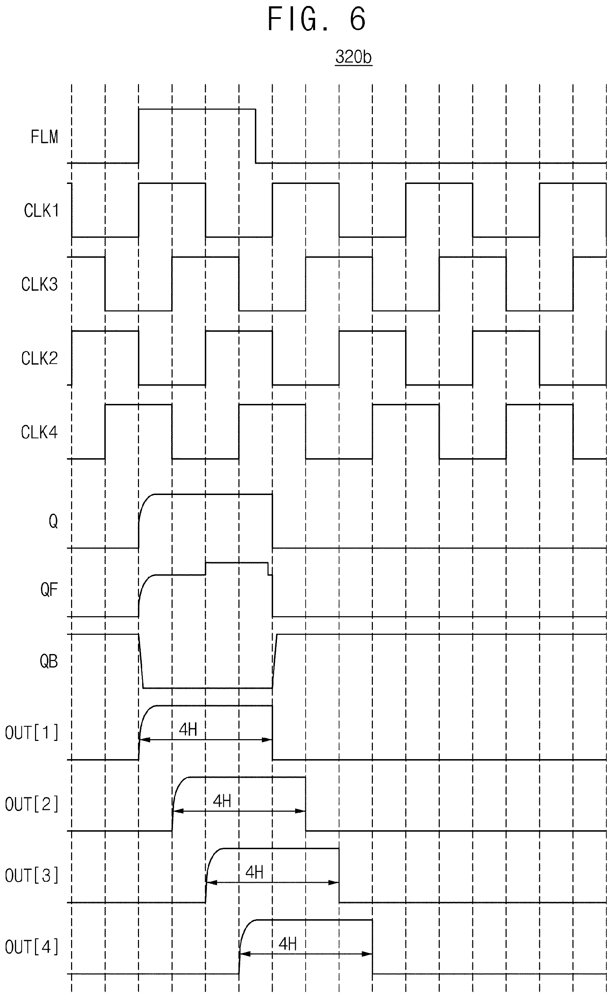

FIG. 5 illustrates a gate driver 300b as a non-limiting example of the gate driver 300 of the display apparatus 10 according to an embodiment of the present inventive concept. FIG. 6 illustrates signals 320b, including input signals, node signals and output signals of the gate driver 300b of FIG. 5.

The gate driver 300b according to the present embodiment is substantially the same as the gate driver 300a of the previous embodiment illustrated in FIGS. 1 to 4 except for the input signal, the node signal and the output signal. Thus, the same reference numerals may be used to refer to the same or like parts as those described in the previous embodiment of FIGS. 1 to 4, and any substantially duplicate or repetitive explanation concerning the above elements may be omitted.

Referring to FIGS. 1, 3, 5 and 6, in the present embodiment, the gate driver 300b may include stages ST[1], ST[2], ST[3], ST[4] and ST[5]. For example, the stages may include a first stage ST[1], a second stage ST[2], a third stage ST[3], a fourth stage ST[4] and a fifth stage ST[5] which are sequentially disposed.

**A** high voltage VGH, a first low voltage VGL, a second low voltage VGL2, a first clock signal CLK1, a second clock signal CLK2, a third clock signal CLK3 and a fourth clock signal CLK4 may be applied to the stages ST[1], ST[2], ST[3], ST[4] and ST[5]. In addition, a reset signal RST may be applied to the stages ST[1], ST[2], ST[3], ST[4] and ST[5]. The first clock signal CLK1, the second clock signal CLK2, the third clock signal CLK3 and the fourth clock signal CLK4 may be applied to the stages ST[1], ST[2], ST[3], ST[4] and ST[5], but any additional carry clock signals for generating a carry signal need not be applied to the stages ST[1], ST[2], ST[3], ST[4] and ST[5].

The first clock signal CLK1, the second clock signal CLK2, the third clock signal CLK3 and the fourth clock signal CLK4 may be alternately applied to the stages ST[1], ST[2], ST[3], ST[4] and ST[5].

For example, the first clock signal CLK1 may be applied to a first clock terminal of the first stage ST[1] and the second clock signal CLK2 may be applied to a second clock terminal of the first stage ST[1].

For example, the third clock signal CLK3 may be applied to a first clock terminal of the second stage ST[2] and the fourth clock signal CLK4 may be applied to a second clock terminal of the second stage ST[2].

For example, the second clock signal CLK2 may be applied to a first clock terminal of the third stage ST[3] and the first clock signal CLK1 may be applied to a second clock terminal of the third stage ST[3].

For example, the fourth clock signal CLK4 may be applied to a first clock terminal of the fourth stage ST[4] and the third clock signal CLK3 may be applied to a second clock terminal of the fourth stage ST[4].

For example, the first clock signal CLK1 may be applied to a first clock terminal of the fifth stage ST[5] and the second clock signal CLK2 may be applied to a second clock terminal of the fifth stage ST[5].

The vertical start signal FLM may be applied to an input terminal IT[1] of the first stage ST[1]. The vertical start signal FLM may be applied to an input terminal IT[2] of the second stage ST[2].

A first carry signal CR[1] of the first stage ST[1] may be applied to an input terminal IT[3] of the third stage ST[3]. A second carry signal CR[2] of the second stage ST[2] may be applied to an input terminal IT[4] of the fourth stage ST[4]. A third carry signal CR[3] of the third stage ST[3] may be applied to an input terminal IT[5] of the fifth stage ST[5].

Carry terminals CT[1] to CT[5] of the first to fifth stages ST[1] to ST[5] may output first to fifth carry signals CR[1] to CR[5].

Gate output terminals OT[1] to OT[5] of the first to fifth stages ST[1] to ST[5] may output first to fifth gate output signals OUT[1] to OUT[5].

A circuit diagram of a stage of the gate driver 300b may be substantially the same as the circuit diagram of FIG. 3, and duplicate or repetitive description may be omitted.

In the present embodiment, a cycle of the first clock signal CLK1 may be four horizontal periods 4H, a cycle of the second clock signal CLK2 may be four horizontal periods 4H, a cycle of the third clock signal CLK3 may be four horizontal periods 4H, a cycle of the fourth clock signal CLK4 may be four horizontal periods 4H and a high period of a pulse of the gate output signal may be four horizontal periods 4H.

In the present embodiment, a high period of the first clock signal CLK1 need not overlap a high period of the second clock signal CLK2. In addition, a high period of the third clock signal CLK3 need not overlap a high period of the fourth clock signal CLK4.

In contrast, the high period of the third clock signal CLK3 may overlap the high period of the first clock signal CLK1. In addition, the high period of the third clock signal CLK3 may overlap the high period of the second clock signal CLK2.

The high period of the fourth clock signal CLK4 may overlap the high period of the first clock signal CLK1. In addition, the high period of the fourth clock signal CLK4 may overlap the high period of the second clock signal CLK2.

According to the present embodiment, all transistors in the gate driver 300b may be configured as the N-type transistors. The gate driver 300b need not include the P-type transistors but may include exclusively N-type transistors. For example, all transistors in the gate driver 300b may be configured to as oxide semiconductor thin film transistors.

To prevent the current leakage, the display panel 100 includes exclusively, N-type transistors and the gate driver 300b integrated with the display panel 100 also includes exclusively, N-type transistors so that the manufacturing process may be simplified and the current leakage may be prevented in the gate driver 300b. The flicker due to the current leakage may be prevented so that the display quality of the display panel 100 may be maximized.

In addition, advantageously the reliability and the stability of the gate output signal OUT[n] may be maximized and the power consumption may be minimized.

In addition, the gate driver 300b need not use the clock signal CLK1, CLK2, CLK3 and CLK4 as the gate output signal OUT[n], but may generate the gate output signal OUT[n] based on power voltages VGH and VGL so that the power consumption increase due to a capacitance of a buffer transistor (e.g., the seventh transistor T7) receiving the clock signal CLK1, CLK2, CLK3 and CLK4 may be prevented. The power voltages VGH and VGL, as well as the voltage levels of the gate output signals OUT[n], are independent of the clock signals CLK1, CLK2, CLK3 and CLK4.

In addition, the gate driver 300b need not receive additional carry clock signals so that a size of the buffer transistor (e.g., the seventh transistor T7) may be sufficiently large so that a falling time of the gate output signal OUT[n] may be decreased.

When the falling time of the gate output signal OUT[n] is decreased, a data voltage of another pixel need not be incorrectly applied to a pixel so that a display quality of the display panel 100 may be maximized.

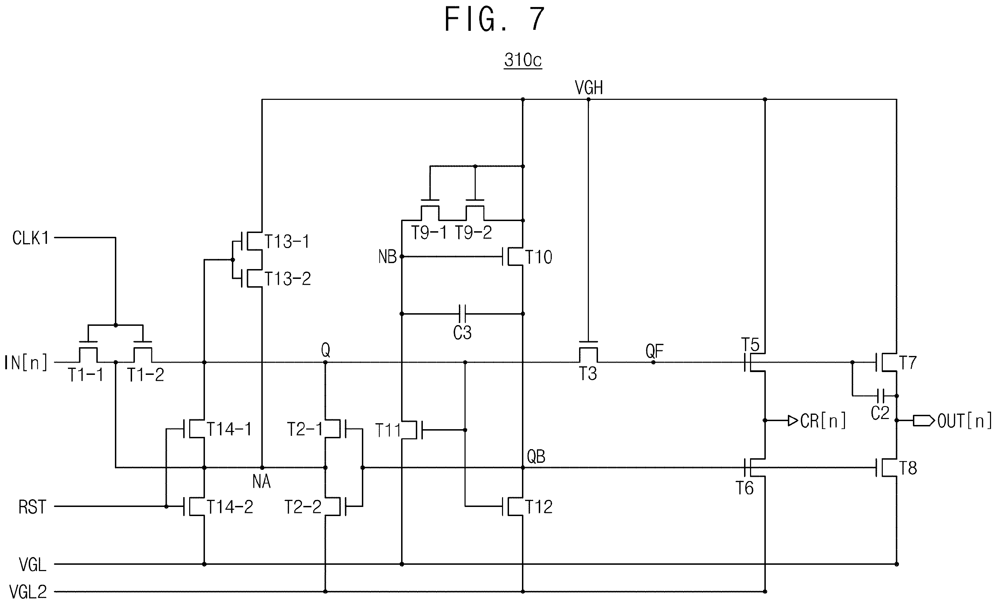

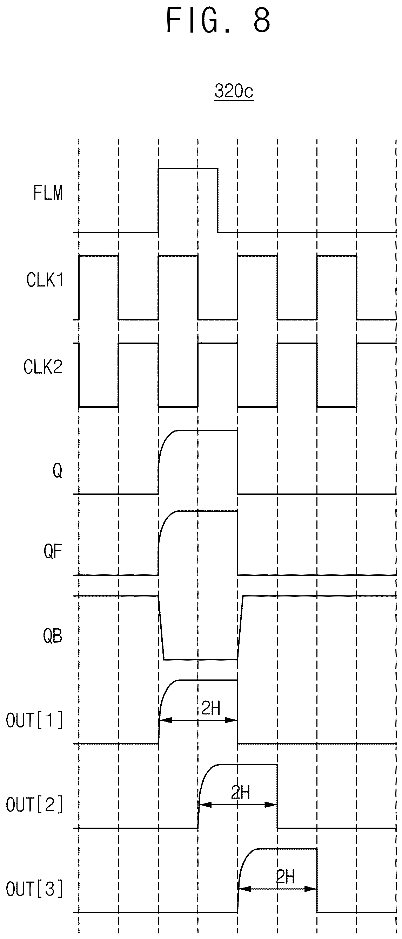

FIG. 7 illustrates a stage 310c as a non-limiting example of a stage of the gate driver 300 of the display apparatus 10 according to an embodiment of the present inventive concept. FIG. 8 illustrates signals 320c including input signals, node signals and output signals of the gate driver 300 that includes the stage 310c of FIG. 7.

The stage 310c of the gate driver 300c according to the present embodiment is substantially the same as the stage 310a of the gate driver 300a of the embodiment illustrated in FIG. 3 except that the stage 310c does not include the boosting circuit. Thus, the same or like reference numerals may be used to refer to the same or like parts as those described in the embodiment of FIGS. 1 to 4 and any repetitive explanation concerning the above elements may be omitted.

Referring to FIGS. 1, 2, 7 and 8, in the present embodiment, the stage 310c need not include the boosting circuit T4 and C1.

Although the stage 310c does not include the boosting circuit T4 and C1, the gate output signal OUT[n] may be stably outputted depending on characteristics of the display panel 100, the gate driver 300 and the display apparatus.

When the boosting circuit T4 and C1 is omitted in this case, an area of the stage of the gate driver 300 may be minimized, and accordingly a dead space of the display apparatus may be minimized.

Even if the fourth transistor T4 of the boosting circuit of FIG. 3 is omitted, the stability and reliability of the gate output signal OUT[n] may be obtained by increasing a capacitance of the first capacitor C1.

In this case, there is no bootstrapping operation of the second control node QF so that a waveform of the signal of the second control node QF may be similar to a waveform of the signal of the first control node Q as shown in FIG. 8.

According to the present embodiment, all transistors in the gate driver 300 may be configured as the N-type transistors. The gate driver 300 need not include any P-type transistors but may include exclusively, N-type transistors. For example, all transistors in the gate driver 300 may be configured as oxide semiconductor thin film transistors.

To prevent the current leakage, the display panel 100 includes exclusively, N-type transistors and the gate driver 300 integrated with the display panel 100 also includes exclusively, N-type transistors so that the manufacturing process may be simplified and the current leakage may be prevented in the gate driver 300. The flicker due to the current leakage may be prevented so that the display quality of the display panel 100 may be maximized.

In addition, advantageously the reliability and the stability of the gate output signal OUT[n] may be maximized and the power consumption may be minimized.

In addition, the gate driver 300 need not use the clock signal CLK1 and CLK2 as the gate output signal OUT[n] but generate the gate output signal OUT[n] based on power voltages VGH and VGL so that the power consumption increase due to a capacitance of a buffer transistor (e.g., the seventh transistor T7) receiving the clock signal CLK1 and CLK2 may be prevented. The power voltages VGH and VGL, as well as the voltage levels of the gate output signal OUT[n], are independent of the clock signals CLK1 and CLK2.

In addition, the gate driver 300 need not receive additional carry clock signals so that a size of the buffer transistor (e.g., the seventh transistor T7) may be sufficiently large so that a falling time of the gate output signal OUT[n] may be decreased.

When the falling time of the gate output signal OUT[n] is decreased, a data voltage of another pixel need not be incorrectly applied to a pixel so that a display quality of the display panel 100 may be maximized.

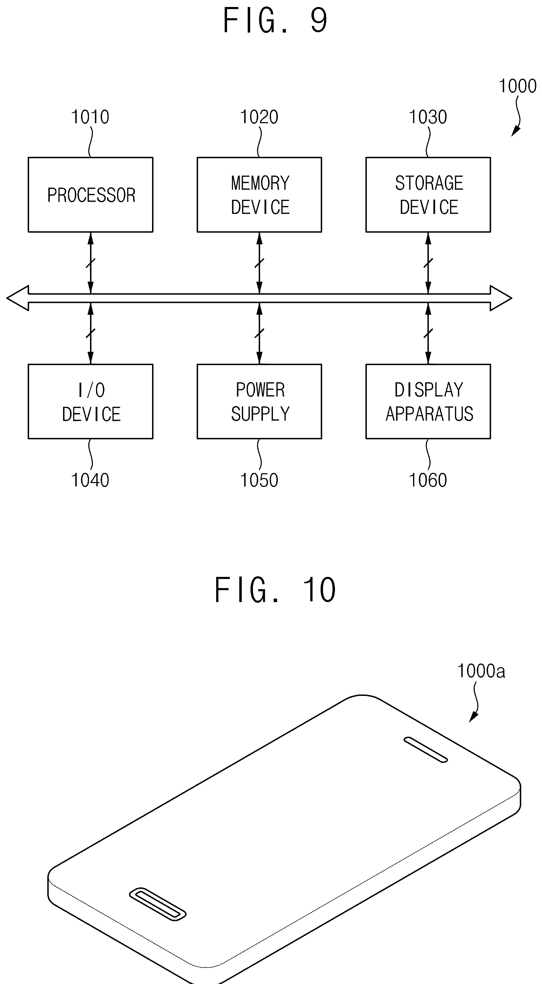

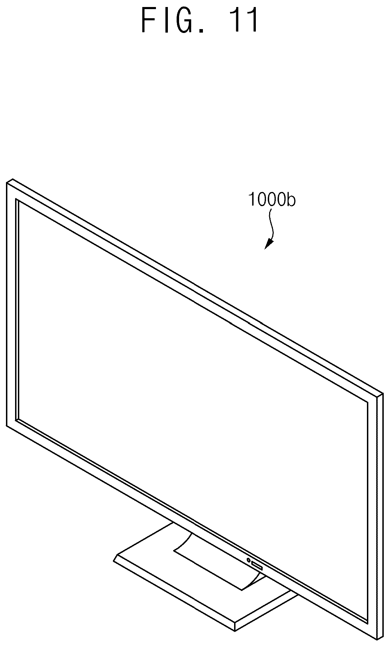

FIG. 9 illustrates an electronic device 1000 according to an embodiment of the present inventive concept. FIG. 10 illustrates a non-limiting example of an electronic device 1000a in which an electronic device of FIG. 9 is implemented as a smart phone. FIG. 11 illustrates a non-limiting example of an electronic device 1000b in which an electronic device of FIG. 9 is implemented as a monitor.

Referring to FIGS. 9 to 11, the electronic device 1000 may include a processor 1010, a memory device 1020, a storage device 1030, an input/output (I/O) device 1040, a power supply 1050, and a display apparatus 1060. Here, the display apparatus 1060 may be the display apparatus of FIG. 1, without limitation thereto. In addition, the electronic device 1000 may further include a plurality of ports for communicating with a video card, a sound card, a memory card, a universal serial bus (USB) device, other electronic apparatuses, or the like.

In an embodiment, as illustrated in FIG. 10, the electronic device 1000 may be implemented as a smartphone. In an embodiment, as illustrated in FIG. 11, the electronic device 1000 may be implemented as a monitor. However, the electronic device 1000 is not limited thereto. For example, the electronic device 1000 may be implemented as a television, a cellular phone, a video phone, a smart pad, a smart watch, a tablet PC, a car navigation system, a laptop, a head mounted display (HMD) device, and the like.

The processor 1010 may perform various computing functions or various tasks. The processor 1010 may be a micro-processor, a central processing unit (CPU), an application processor (AP), and the like. The processor 1010 may be coupled to other components via an address bus, a control bus, a data bus, or the like. Further, the processor 1010 may be coupled to an extended bus such as a peripheral component interconnection (PCI) bus.

The processor 1010 may output the input image data IMG and the input control signal CONT to the driving controller 200 of FIG. 1.

The memory device 1020 may store data for operations of the electronic device 1000. For example, the memory device 1020 may include at least one non-volatile memory device such as an erasable programmable read-only memory (EPROM) device, an electrically erasable programmable read-only memory (EEPROM) device, a flash memory device, a phase change random-access memory (PRAM) device, a resistance random-access memory (RRAM) device, a nano floating gate memory (NFGM) device, a polymer random-access memory (PoRAM) device, a magnetic random-access memory (MRAM) device, a ferroelectric random-access memory (FRAM) device, and the like and/or at least one volatile memory device such as a dynamic random-access memory (DRAM) device, a static random-access memory (SRAM) device, a mobile DRAM device, and the like.

The storage device 1030 may include a solid state drive (SSD) device, a hard disk drive (HDD) device, a CD-ROM device, and the like. The I/O device 1040 may include an input device such as a keyboard, a keypad, a mouse device, a touch-pad, a touch-screen, and the like and an output device such as a printer, a speaker, and the like. In some embodiments, the display apparatus 1060 may be included in the I/O device 1040. The power supply 1050 may provide power for operations of the electronic device 1000. The display apparatus 1060 may be coupled to other components via the buses or other communications links.

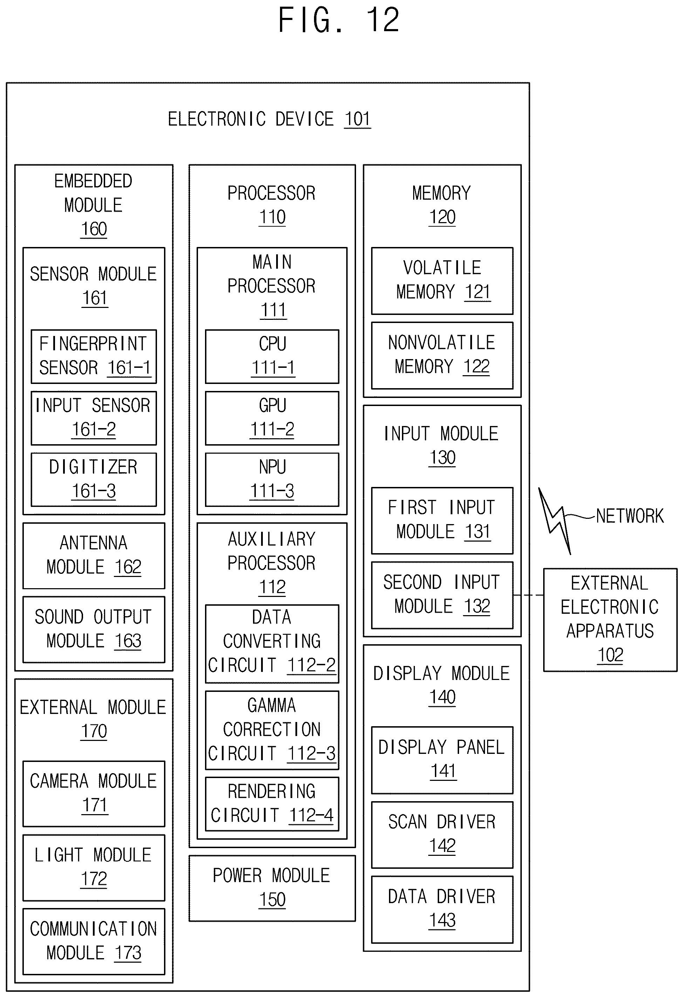

FIG. 12 illustrates an electronic device 101 according to an embodiment of the present inventive concept.

Referring to FIGS. 1 to 12, the electronic device 101 outputs various information through a display module 140 in an operating system. When a processor 110 executes an application stored in a memory 120, the display module 140 provides application information to a user through a display panel 141.

The processor 110 obtains an external input through an input module 130 or a sensor module 161 and executes an application corresponding to the external input. For example, when the user selects a camera icon displayed on the display panel 141, the processor 110 obtains a user input through an input sensor 161-2 and activates a camera module 171. The processor 110 transfers image data corresponding to a captured image obtained through the camera module 171 to the display module 140. The display module 140 may display an image corresponding to the captured image through the display panel 141.

In an embodiment, when a personal information authentication is executed in the display module 140, a fingerprint sensor 161-1 obtains input fingerprint information as input data. The processor 110 compares input data obtained through the fingerprint sensor 161-1 with authentication data stored in the memory 120, and executes an application according to a comparison result. The display module 140 may display information executed according to application logic through the display panel 141.

In an embodiment, when a music streaming icon displayed on the display module 140 is selected, the processor 110 obtains a user input through the input sensor 161-2 and activates a music streaming application stored in the memory 120. When a music execution command is input in the music streaming application, the processor 110 activates a sound output module 163 to provide sound information corresponding to the music execution command to the user.

In the above, the operation of the electronic device 101 is briefly described. Hereinafter, a configuration of the electronic device 101 is described in detail. Some of elements of the electronic device 101 described later may be integrated and provided as one element, or one element may be separated as two or more elements.

The electronic device 101 may communicate with an external electronic device 102 through a network (e.g., a short-range wireless communications network or a long-range wireless communications network). According to an embodiment, the electronic device 101 may include the processor 110, the memory 120, the input module 130, the display module 140, a power module 150, an embedded module 160, and an external module 170. According to an embodiment, in the electronic device 101, at least one of the above-described elements may be omitted or one or more other apparatus may be added. According to an embodiment, some of the above-described elements (e.g., the sensor module 161, an antenna module 162 or the sound output module 163) may be integrated into another element (e.g., the display module 140).

The processor 110 may execute software to control at least one other element (e.g., hardware or software element) of the electronic device 101 connected to the processor 110 and to perform various data processing or operations. According to an embodiment, as at least part of the data processing or the operations, the processor 110 may store received instructions or data from other elements (e.g., the input module 130, the sensor module 161 or a communications module 173) in a volatile memory 121, may process the instructions or data stored in the volatile memory 121 and may store result data of the processing in a nonvolatile memory 122.

The processor 110 may include a main processor 111 and an auxiliary processor 112. The main processor 111 may include at least one of a central processing unit (CPU) 111-1 and an application processor (AP). The main processor 111 may further include any one or more of a graphic processing unit (GPU) 111-2, a communications processor (CP) and an image signal processor (ISP). The main processor 111 may further include a neural processing unit (NPU) 111-3. The neural network processing unit 111-3 is a processor specialized in processing an artificial intelligence model. The artificial intelligence model may be generated through a machine learning. The artificial intelligence model may include a plurality of artificial neural network layers. The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN) and a deep Q-networks or a combination of two or more of the above. However, the artificial neural network is not limited to the above examples. The artificial intelligence model may include software structures, in addition to hardware structures or instead of the hardware structures. At least two of the above-described processing units and the above-described processors may be implemented as an integrated element (e.g., a single chip) or each may be implemented as independent elements (e.g., in a plurality of chips).

The auxiliary processor 112 may include a controller. The controller may include an interface conversion circuit and a timing control circuit. The controller receives an image signal from the main processor 111, converts a data format of the image signal to meet interface specifications with the display module 140, and outputs image data. The controller may output various control signals for driving the display module 140.

The auxiliary processor 112 may further include a data converting circuit 112-2, a gamma correction circuit 112-3 and a rendering circuit 112-4. The data converting circuit 112-2 may receive the image data from the controller and may compensate the image data such that the image is displayed with a desired luminance according to characteristics of the electronic device 101 or a user setting or may convert the image data to reduce a power consumption or compensate for afterimages. The gamma correction circuit 112-3 may convert the image data or a gamma reference voltage such that the image displayed on the electronic device 101 has desired gamma characteristics. The rendering circuit 112-4 may receive the image data from the controller and may render the image data based on a pixel arrangement of the display panel 141 included in the electronic device 101. At least one of the data converting circuit 112-2, the gamma correction circuit 112-3 and the rendering circuit 112-4 may be integrated into another element (e.g., the main processor 111 or the controller). At least one of the data converting circuit 112-2, the gamma correction circuit 112-3 and the rendering circuit 112-4 may be integrated into a data driver 143 to be described later.

The memory 120 may store various data used by at least one element (e.g., the processor 110 or the sensor module 161) of the electronic device 101 and input data or output data for commands related thereto. The memory 120 may include at least one of the volatile memory 121 and the nonvolatile memory 122.

The input module 130 may receive commands or data used to the elements (e.g., the processor 110, the sensor module 161 or the sound output module 163) of the electronic device 101 from the outside of the electronic device 101 (e.g., from the user or from an external electronic apparatus such as the electronic device 102).

The input module 130 may include a first input module 131 for receiving commands or data from the user and a second input module 132 for receiving commands or data from the external electronic device 102. The first input module 131 may include a microphone, a mouse, a keyboard, a key (e.g., a button) or a pen (e.g., a passive pen or an active pen). The second input module 132 may support a designated protocol capable of connecting to the external electronic device 102 by wire or wirelessly. According to an embodiment, the second input module 132 may include a high definition multimedia interface (HDMI), a universal serial bus (USB) interface, an SD card interface or an audio interface. The second input module 132 may include a connector physically connected to the external electronic device 102, for example, an HDMI connector, a USB connector, an SD card connector, or an audio connector (e.g., a headphone connector).

The display module 140 visually provides information to the user. The display module 140 may include the display panel 141, a scan driver 142 and the data driver 143. The display module 140 may further include a window, a chassis and a bracket to protect the display panel 141.

The display panel 141 may include a liquid crystal display panel, an organic light emitting display panel or an inorganic light emitting display panel. A type of the display panel 141 is not particularly limited. The display panel 141 may be a rigid type or a flexible type capable of being rolled or folded. The display module 140 may further include a supporter or a heat dissipation member supporting the display panel 141.

The scan driver 142 may be mounted on the display panel 141 as a driving chip. Alternatively, the scan driver 142 may be integrated with the display panel 141. For example, the scan driver 142 may include an amorphous silicon TFT gate driver circuit (ASG) integrated with the display panel 141, a low temperature polycrystalline silicon (LTPS) TFT gate driver circuit integrated with the display panel 141, or an oxide semiconductor TFT gate driver circuit (OSG) integrated with the display panel 141. The scan driver 142 receives a control signal from the controller and outputs the scan signals to the display panel 141 in response to the control signal.

The display module 140 may further include a light emission driver. The light emission driver outputs a light emission control signal to the display panel 141 in response to a control signal received from the controller. The light emission driver may be formed independently from the scan driver 142. Alternatively, the light emission driver and the scan driver 142 may be integrally formed.

The data driver 143 receives a control signal from the controller and converts the image data into an analog voltage (e.g., the data voltage) and output the data voltages to the display panel 141 in response to the control signal.

The data driver 143 may be integrated into another element (e.g., the controller). The functions of the interface conversion circuit and the timing control circuit of the controller described above may be integrated into the data driver 143.

The display module 140 may further include a voltage generating circuit. The voltage generating circuit may output various voltages for driving the display panel 141.

The power module 150 supplies power to elements of the electronic device 101. The power module 150 may include a battery which supplies a power voltage. The battery may include a non-rechargeable primary cell, a rechargeable secondary cell or a fuel cell. The power module 150 may include a power management integrated circuit (PMIC). The PMIC supplies optimized power to each of the above-described modules and modules described later. The power module 150 may include a wireless power transmission/reception member electrically connected to the battery. The wireless power transmission/reception member may include a plurality of antenna radiators in a form of coils.

The electronic device 101 may further include the embedded module 160 and the external module 170. The embedded module 160 may include the sensor module 161, the antenna module 162 and the sound output module 163. The external module 170 may include the camera module 171, a light module 172 and the communications module 173.

The sensor module 161 may detect an input by a user's body or an input by the pen among the first input module 131, and generate an electrical signal or data value corresponding to the input. The sensor module 161 may include at least one of the fingerprint sensor 161-1, the input sensor 161-2 and a digitizer 161-3.

The fingerprint sensor 161-1 may generate a data value corresponding to a user's fingerprint. The fingerprint sensor 161-1 may include one of an optical fingerprint sensor or a capacitive fingerprint sensor.

The input sensor 161-2 may generate data values corresponding to coordinate information of the input by the user's body or the input by the pen. The input sensor 161-2 generates a capacitance change due to an input as a data value. The input sensor 161-2 may detect an input by the passive pen or transmit/receive data to/from the active pen.

The input sensor 161-2 may measure bio-signals such as a blood pressure, a moisture, or a body fat. For example, when a user touches a part of his body to a sensor layer or a sensing panel and does not move for a certain period of time, the input sensor 161-2 may detect the bio-signal based on a change in an electric field caused by the part of the body so that the display module 140 may output user's desired information.

The digitizer 161-3 may generate a data value corresponding to the coordinate information input by the pen. The digitizer 161-3 generates an amount of electromagnetic change by the input as a data value. The digitizer 161-3 may detect an input by the passive pen or transmit/receive data to/from the active pen.

**At** least one of the fingerprint sensor 161-1, the input sensor 161-2 and the digitizer 161-3 may be formed as a sensor layer on the display panel 141 through a continuous process. The fingerprint sensor 161-1, the input sensor 161-2 and the digitizer 161-3 may be disposed on the display panel 141. At least one of the fingerprint sensor 161-1, the input sensor 161-2 and the digitizer 161-3, for example, the digitizer 161-3, may be disposed under the display panel 141.

At least two or more of the fingerprint sensor 161-1, the input sensor 161-2 and the digitizer 161-3 may be integrated into the sensing panel through the same process. When at least two or more of the fingerprint sensor 161-1, the input sensor 161-2 and the digitizer 161-3 are integrated into the sensing panel, the sensing panel may be disposed between the display panel 141 and a window disposed over an upper surface of the display panel 141. According to an embodiment, the sensing panel may be disposed on the window. The present inventive concept is not limited to a position of the sensing panel.

At least one of the fingerprint sensor 161-1, the input sensor 161-2 and the digitizer 161-3 may be embedded in the display panel 141. For example, at least one of the fingerprint sensor 161-1, the input sensor 161-2 and the digitizer 161-3 is formed simultaneously with the display panel 141 through a process of forming elements included in the display panel 141 (e.g., light emitting elements, transistors, or the like.).

In addition, the sensor module 161 may generate an electrical signal or a data value corresponding to an internal state or an external state of the electronic device 101. For example, the sensor module 161 may further include a gesture sensor, a gyro sensor, a barometric pressure sensor, a magnetic sensor, an acceleration sensor, a grip sensor, a proximity sensor, a color sensor, an IR (infrared) sensor, a biosensor, a temperature sensor, a humidity sensor or an illuminance sensor.

The antenna module 162 may include one or more antennas for transmitting a signal or power to outside or receiving a signal or power from outside. According to an embodiment, the communications module 173 may transmit a signal to an external electronic device or receive a signal from an external electronic device through an antenna suitable for a communications method. An antenna pattern of the antenna module 162 may be integrated with an element of the display module 140 (e.g., the display panel 141) or the input sensor 161-2.

The sound output module 163 is a device for outputting sound signals to the outside of the electronic device 101. For example, the sound output module 163 may include a speaker used for general purposes such as playing multimedia or recording and a receiver used exclusively for receiving a call. According to an embodiment, the receiver may be formed integrally with or separately from the speaker. A sound output pattern of the sound output module 163 may be integrated with the display module 140.

The camera module 171 may capture still images and moving images. According to an embodiment, the camera module 171 may include one or more lenses, an image sensor or an image signal processor. The camera module 171 may further include an infrared camera capable of determining a presence or an absence of a user, the user's location and the user's gaze.

The light module 172 may provide a light. The light module 172 may include a light emitting diode or a xenon lamp. The light module 172 may operate in conjunction with the camera module 171 or operate independently.

The communications module 173 may support establishment of a wired or wireless communications channel between the electronic device 101 and the external electronic device 102 and communications through the established communications channel. The communications module 173 may include one or both of a wireless communications module such as a cellular communications module, a short-distance wireless communications module, or a global navigation satellite system (GNSS) communications module and a wired communications module such as a local area network (LAN) communications module, or a power line communications module. The communications module 173 may communicate with the external electronic device 102 through a short-range communications network such as BLUETOOTH^{®}, a short-range wireless communications standard promulgated by the Bluetooth Special Interest Group; WI-FI DIRECT^{®}, a wireless communications standard promulgated by the Wi-Fi Alliance; infrared data association (IrDA); or a long-distance communications network such as a cellular network, the Internet, or a computer network (e.g., LAN or WAN). The various types of communications modules 173 described above may be implemented as a single chip or may be implemented as separate chips.

The input module 130, the sensor module 161 and the camera module 171 may be used to control the operation of the display module 140 in conjunction with the processor 110.

The processor 110 outputs commands or data to the display module 140, the sound output module 163, the camera module 171 or the light module 172 based on the input data received from the input module 130. For example, the processor 110 may generate image data corresponding to input data applied through a mouse or an active pen, and output the generated image data to the display module 140 or the processor 110 may generate command data corresponding to the input data and output the generated command data to the camera module 171 or the light module 172. When input data is not received from the input module 130 for a certain period of time, the processor 110 converts an operation mode of the electronic device 101 into a low power mode or a sleep mode so that a power consumption of the electronic device 101 may be minimized.

The processor 110 outputs commands or data to the display module 140, the sound output module 163, the camera module 171 or the light module 172 based on sensed data received from the sensor module 161. For example, the processor 110 may compare authentication data applied by the fingerprint sensor 161-1 with authentication data stored in the memory 120, and then execute an application according to the comparison result. The processor 110 may execute commands or output corresponding image data to the display module 140 based on the sensed data sensed by the input sensor 161-2 or the digitizer 161-3. When the sensor module 161 includes a temperature sensor, the processor 110 may receive temperature data for the temperature measured from the sensor module 161 and may further perform luminance correction on the image data based on the temperature data.

The processor 110 may receive determined data about the presence or the absence of the user, the user's location and the user's gaze from the camera module 171. The processor 110 may further perform luminance correction on the image data based on the determined data. For example, the processor 110, which determines the presence or the absence of the user through an input from the camera module 171, may display image data having the luminance corrected by the data converting circuit 112-2 or the gamma correction circuit 112-3 to the display module 140.

Some of the above elements may be connected to each other through a communications method between peripheral devices such as a bus, a general purpose input/output (GPIO), a serial peripheral interface (SPI), a mobile industry processor interface (MIPI), or an ultra path interconnect (UPI) link to exchange signals (e.g., commands or data) with each other. The processor 110 may communicate with the display module 140 through an agreed interface. For example, the processor 110 may communicate with the display module 140 through any one of the above communications methods. The present invention is not limited to the above communications methods.

The electronic device 101 according to various embodiments disclosed in the disclosure may be various types of apparatuses. For example, the electronic device 101 may include at least one of a portable communications apparatus (e.g., a smart phone), a computer apparatus, a portable multimedia apparatus, a portable medical apparatus, a camera, a wearable device and a home appliance. The electronic device 101 according to the embodiment of the disclosure is not limited to the aforementioned apparatuses.

For example, the display panel 100 of FIG. 1 may correspond to the display panel 141 of FIG. 12. For example, the driving controller 200 of FIG. 1 may correspond to the controller of the auxiliary processor 112 of FIG. 12. For example, the gate driver 300 of FIG. 1 may correspond to the scan driver 142 of FIG. 12. For example, the data driver 500 of FIG. 1 may correspond to the data driver 143 of FIG. 12.

According to the embodiments of the gate driver, the display apparatus and the electronic device, the power consumption of the display apparatus may be minimized and the display quality of the display panel may be maximized.

The foregoing is illustrative of the present inventive concept and is not to be construed as limiting thereof. Although illustrative embodiments of the present inventive concept have been described, those of ordinary skill in the pertinent art will readily appreciate that many modifications are possible in the embodiments without materially departing from the novel teachings of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of the present inventive concept and is not to be construed as limited to the specific embodiments disclosed, and that modifications to the disclosed embodiments, as well as other embodiments, are intended to be included within the scope of the appended claims. The present inventive concept is defined by the following claims, with equivalents of the claims to be included therein.

## Claims

1. A gate driver (300, 300a, 300b, 300c) comprising a plurality of stages, wherein a stage of the plurality of stages comprises:
a first transistor comprising a first sub-transistor including a control electrode connected to a first clock signal line, a first electrode connected to an input signal line and a second electrode connected to a first intermediate node, and a second sub-transistor including a control electrode connected to the first clock signal line, a first electrode connected to the first intermediate node (NA) and a second electrode connected to a first control node (Q);
a second transistor comprising a first sub-transistor including a control electrode connected to a third control node (QB), a first electrode connected to the first intermediate node (NA) and a second electrode connected to the first control node (Q), and a second sub-transistor including a control electrode connected to the third control node (QB), a first electrode connected to a second low voltage line and a second electrode connected to the first intermediate node (NA);
a third transistor (T3) including a control electrode connected to a high voltage line, a first electrode connected to the first control node (Q) and a second electrode connected to a second control node (QF);
a fifth transistor (T5) including a control electrode connected to the second control node (QF), a first electrode connected to the high voltage line and a second electrode connected to a carry output terminal;
a sixth transistor (T6) including a control electrode connected to the third control node (QB), a first electrode connected to the second low voltage line and a second electrode connected to the carry output terminal;
a seventh transistor (T7) including a control electrode connected to the second control node (QF), a first electrode connected to the high voltage line and a second electrode connected to a gate output terminal (OT[1] - OT[5]); and
an eighth transistor (T8) including a control electrode connected to the third control node (QB), a first electrode connected to a first low voltage line and a second electrode connected to the gate output terminal (OT[1] - OT[5]).

2. The gate driver (300, 300a, 300b, 300c) of claim 1, wherein the stage of the plurality of stages further comprises:
a fourth transistor (T4) including a control electrode connected to the second control node (QF), a first electrode connected to a second clock signal line and a second electrode connected to a second electrode of a first capacitor (C1),
wherein the first capacitor (C1) includes a first electrode connected to the second control node (QF).

3. The gate driver (300, 300a, 300b, 300c) of claim 1 or 2, wherein the stage of the plurality of stages further comprises a second capacitor (C2) including a first electrode connected to the second control node (QF) and a second electrode connected to the gate output terminal (OT[1] - OT[5]).

4. The gate driver (300, 300a, 300b, 300c) of claims 1 to 3, wherein the stage (310a, 310c) of the plurality of stages (310a, 310c) further comprises:
a ninth transistor comprising a first sub-transistor including a control electrode connected to the high voltage line, a first electrode connected to a first node (NB) and a second electrode connected to a ninth intermediate node, and a second sub-transistor including a control electrode to the high voltage line, a first electrode connected to the ninth intermediate node and a second electrode connected to the high voltage line; and
a tenth transistor (T10) including a control electrode connected to the first node (NB), a first electrode connected to the high voltage line and a second electrode connected to the third control node (QB) and/or wherein the stage of the plurality of stages further comprises a third capacitor including a first electrode connected to the first node (NB) and a second electrode connected to the third control node (QB) and/or wherein the stage of the plurality of stages further comprises:
an eleventh transistor (T11) including a control electrode connected to the first control node (Q), a first electrode connected to the first low voltage line and a second electrode connected to the first node (NB); and
a twelfth transistor (T12) including a control electrode connected to the first control node (Q), a first electrode connected to the second low voltage line and a second electrode connected to the third control node (QB).

5. The gate driver (300, 300a, 300b, 300c) of claims 1 to 4, wherein the stage of the plurality of stages further comprises:
a thirteenth transistor comprising a first sub-transistor including a control electrode connected to the first control node (Q), a first electrode connected to the high voltage line and a second electrode connected to a thirteenth intermediate node, and a second sub-transistor including a control electrode connected to the first control node (Q), a first electrode connected to the thirteenth intermediate node and a second electrode connected to the first intermediate node.

6. The gate driver (300, 300a, 300b, 300c) of claims 1 to 5, wherein the stage of the plurality of stages further comprises:
a fourteenth transistor comprising a first sub-transistor including a control electrode connected to a reset signal line, a first electrode connected to the first intermediate node (NA) and a second electrode connected to the first control node (Q), and a second sub-transistor including a control electrode connected to the reset signal line, a first electrode connected to the first low voltage line and a second electrode connected to the first intermediate node.

7. The gate driver (300, 300a, 300b, 300c) of claims 1 to 6, wherein:
the plurality of stages (310a, 310c) comprises a first stage (ST[1]), a second stage (ST[2]), a third stage (ST[3]) and a fourth stage (ST[4]) which are sequentially disposed,
a carry signal of the first stage (ST[1]) is connected to the second stage (ST[2]),
a carry signal of the second stage (ST[2]) is connected to the third stage (ST[3]),
a carry signal of the third stage (ST[3]) is connected to the fourth stage (ST[4]),
the first clock signal line is connected to a first clock terminal of the first stage (ST[1]) and a second clock signal line is connected to a second clock terminal of the first stage (ST[1]),
the second clock signal line is connected to a first clock terminal of the second stage (ST[2]) and the first clock signal line is connected to a second clock terminal of the second stage (ST[2]),
the first clock signal line is connected to a first clock terminal of the third stage (ST[3]) and the second clock signal line is connected to a second clock terminal of the third stage (ST[3]), and
the second clock signal line is connected to a first clock terminal of the fourth stage (ST[4]) and the first clock signal line is connected to a second clock terminal of the fourth stage (ST[4]).

8. The gate driver (300, 300a, 300b, 300c) of claim 7, wherein:
a cycle of a first clock signal (CLK1) of the first clock signal line is two horizontal periods,
a cycle of a second clock signal (CLK2) of the second clock line signal is two horizontal periods, and
a high period of a pulse of a gate output signal (OUT[n]) is two horizontal periods and/or wherein a high period of the first clock signal (CLK1) does not overlap a high period of the second clock signal.

9. The gate driver (300, 300a, 300b, 300c) of claims 1 to 8, wherein:
the plurality of stages comprises a first stage (ST[1]), a second stage (ST[2]), a third stage (ST[3]) and a fourth stage (ST[4]) which are sequentially disposed,
a carry signal of the first stage (ST[1]) is connected to the third stage,
a carry signal of the second stage (ST[2]) is connected to the fourth stage,
the first clock signal (CLK1) is applied to a first clock terminal of the first stage (ST[1]) and a second clock signal (CLK2) is applied to a second clock terminal of the first stage,
a third clock signal (CLK3) is applied to a first clock terminal of the second stage (ST[2]) and a fourth clock signal (CLK4) is applied to a second clock terminal of the second stage,
the second clock signal (CLK2) is applied to a first clock terminal of the third stage (ST[3]) and the first clock signal (CLK1) is applied to a second clock terminal of the third stage, and
the fourth clock signal (CLK4) is applied to a first clock terminal of the fourth stage (ST[4]) and the third clock signal (CLK3) is applied to a second clock terminal of the fourth stage.

10. The gate driver (300, 300a, 300b, 300c) of claim 9, wherein:
a cycle of the first clock signal (CLK1) is four horizontal periods,
a cycle of the second clock signal (CLK2) is four horizontal periods,
a cycle of the third clock signal (CLK3) is four horizontal periods,
a cycle of the fourth clock signal (CLK4) is four horizontal periods, and
a high period of a pulse of a gate output signal (OUT[n]) is four horizontal periods.

11. The gate driver (300, 300a, 300b, 300c) of claim 10, wherein:
a high period of the first clock signal (CLK1) does not overlap a high period of the second clock signal (CLK2),
a high period of the third clock signal (CLK3) overlaps the high period of the first clock signal (CLK1), and
the high period of the third clock signal (CLK3) overlaps the high period of the second clock signal (CLK2).

12. A gate driver (300, 300a, 300b, 300c) comprising:
an input circuit configured to transmit an input signal to a first control node (Q) in response to a first clock signal (CLK1);
a pull-up circuit configured to pull up a gate output signal (OUT[n]) to a high voltage (VGH) in response to a signal of a second control node (QF);
a pull-down circuit configured to pull down the gate output signal (OUT[n]) to a first low voltage (VGL) in response to a signal of a third control node (QB);
a node separating circuit including a control electrode configured to receive the high voltage (VGH), a first electrode connected to the first control node (Q) and a second electrode connected to the second control node (QF);
a first control node (Q) control circuit configured to control a signal of the first control node (Q) in response to the signal of the third control node (QB); and
a third control node (QB) control circuit configured to control the signal of the third control node (QB) in response to the signal of the first control node (Q).

13. An electronic device (101, 102, 1000, 1000a, 1000b) comprising:
a display panel (100, 141) comprising a pixel;
a gate driver (300, 300a, 300b, 300c) configured to output a gate signal to the pixel; and
a data driver (143, 500) configured to output a data voltage to the pixel,
wherein the gate driver (300, 300a, 300b, 300c) comprises:
a first transistor comprising a first sub-transistor including a control electrode configured to receive a first clock signal (CLK1), a first electrode configured to receive an input signal and a second electrode connected to a first intermediate node, and a second sub-transistor including a control electrode configured to receive the first clock signal (CLK1), a first electrode connected to the first intermediate node (NA) and a second electrode connected to a first control node (Q);
a second transistor comprising a first sub-transistor including a control electrode connected to a third control node (QB), a first electrode connected to the first intermediate node (NA) and a second electrode connected to the first control node (Q), and a second sub-transistor including a control electrode connected to the third control node (QB), a first electrode configured to receive a second low voltage (VGL2) and a second electrode connected to the first intermediate node (NA);
a third transistor (T3) including a control electrode configured to receive a high voltage (VGH), a first electrode connected to the first control node (Q) and a second electrode connected to a second control node (QF);
a fifth transistor (T5) including a control electrode connected to the second control node (QF), a first electrode configured to receive the high voltage (VGH) and a second electrode connected to a carry output terminal;
a sixth transistor (T6) including a control electrode connected to the third control node (QB), a first electrode configured to receive the second low voltage (VGL2) and a second electrode connected to the carry output terminal;
a seventh transistor (T7) including a control electrode connected to the second control node (QF), a first electrode configured to receive the high voltage (VGH) and a second electrode connected to a gate output terminal (OT[1] - OT[5]); and
an eighth transistor (T8) including a control electrode connected to the third control node (QB), a first electrode configured to receive a first low voltage (VGL) and a second electrode connected to the gate output terminal (OT[1] - OT[5]).

14. The electronic device (101, 102, 1000, 1000a, 1000b) of claim 13, wherein the gate driver (300, 300a, 300b, 300c) further comprises:
a fourth (T4) transistor including a control electrode connected to the second control node (QF), a first electrode configured to receive a second clock signal (CLK2) and a second electrode connected to a second electrode of a first capacitor (C1),
wherein the first capacitor (C1) includes a first electrode connected to the second control node (QF) and the second electrode and/or wherein the gate driver (300, 300a, 300b, 300c) further comprises a second capacitor (C2) including a first electrode connected to the second control node (QF) and a second electrode connected to the gate output terminal (OT[1] - OT[5]).

15. The electronic device (101, 102, 1000, 1000a, 1000b) of claim 13, wherein the gate driver (300, 300a, 300b, 300c) further comprises:
a ninth transistor comprising a first sub-transistor including a control electrode configured to receive the high voltage (VGH), a first electrode connected to a first node (NB) and a second electrode connected to a ninth intermediate node, and a second sub-transistor including a control electrode configured to receive the high voltage (VGH), a first electrode connected to the ninth intermediate node and a second electrode configured to receive the high voltage (VGH); and
a tenth transistor (T10) including a control electrode connected to the first node, a first electrode configured to receive the high voltage (VGH) and a second electrode connected to the third control node (QB) and/or wherein the electronic device (101, 102, 1000, 1000a, 1000b) is configured as a display apparatus (10, 1060) and further comprising:
a driving controller (200) configured to control the gate driver (300, 300a, 300b, 300c) and the data driver (143, 500); and
a processor (110, 1010) configured to output input image data to the driving controller (200).
